(19) Europäisches Patentamt
European Patent Office
Office européen des brevets

(11) **EP 3 447 549 B1**

(12) **FASCICULE DE BREVET EUROPEEN**

(45) Date de publication et mention de la délivrance du brevet:
**08.07.2020 Bulletin 2020/28**

(51) Int Cl.:
*G02B 6/122* (2006.01)          *H01S 5/10* (2006.01)
*H01S 5/125* (2006.01)          *H01S 5/183* (2006.01)
*G02B 6/12* (2006.01)          *G02B 6/10* (2006.01)

(21) Numéro de dépôt: **18189984.0**

(22) Date de dépôt: **21.08.2018**

(54) **STRUCTURE SEMICONDUCTRICE À MEMBRANE SUSPENDUE EN TENSION COMPORTANT UNE CAVITÉ OPTIQUE**

HALBLEITERSTRUKTUR MIT GESPANNT AUFGEHÄNGTER MEMBRAN, DIE EINEN OPTISCHEN HOHLRAUM ENTHÄLT

SEMICONDUCTOR STRUCTURE WITH SUSPENDED MEMBRANE UNDER STRESS COMPRISING AN OPTICAL CAVITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.08.2017 FR 1757815**

(43) Date de publication de la demande:
**27.02.2019 Bulletin 2019/09**

(73) Titulaire: **Commissariat à l'Énergie Atomique et aux Énergies Alternatives 75015 Paris (FR)**

(72) Inventeurs:
• **REBOUD, Vincent**
  **75013 Paris (FR)**
• **BOUTAMI, Salim**
  **38100 Grenoble (FR)**

(74) Mandataire: **GIE Innovation Competence Group 310, avenue Berthelot 69372 Lyon Cedex 08 (FR)**

(56) Documents cités:
**US-A1- 2017 093 130      US-B1- 6 711 200**

• **JAN PETYKIEWICZ ET AL: "Direct Bandgap Light Emission from Strained Germanium Nanowires Coupled with High-Q Nanophotonic Cavities", NANO LETTERS, vol. 16, no. 4, 2 mars 2016 (2016-03-02), pages 2168-2173, XP055477851, ISSN: 1530-6984, DOI: 10.1021/acs.nanolett.5b03976**
• **GASSENQ A ET AL: "Distributed Bragg reflectors integration in highly strained Ge micro-bridges on 200 mm GeOI substrates for laser applications", 2015 IEEE 12TH INTERNATIONAL CONFERENCE ON GROUP IV PHOTONICS (GFP), IEEE, 26 août 2015 (2015-08-26), pages 51-52, XP032798017, DOI: 10.1109/GROUP4.2015.7305999**
• **GASSENQ A ET AL: "1.9% bi-axial tensile strain in thick germanium suspended membranes fabricated in optical germanium-on-insulator substrates for laser applications", APPLIED PHYSICS LETTERS, A I P PUBLISHING LLC, US, vol. 107, no. 19, 9 novembre 2015 (2015-11-09), XP012202293, ISSN: 0003-6951, DOI: 10.1063/1.4935590 [extrait le 1901-01-01]**

**Description**

**DOMAINE TECHNIQUE**

Le domaine de l'invention est celui des structures semiconductrices réalisées en un composé semiconducteur cristallin, comportant une membrane dont une portion centrale est suspendue et mise en tension par des bras tenseurs, ainsi qu'une cavité optique. L'invention s'applique en particulier aux dispositifs optoélectroniques comportant une telle structure semiconductrice, tels que, par exemple, les sources laser.

**ÉTAT DE LA TECHNIQUE ANTÉRIEURE**

Dans diverses applications microélectroniques ou optoélectroniques, il peut être avantageux d'utiliser une couche en un composé semiconducteur cristallin, de préférence monocristallin, présentant une contrainte mécanique en tension. C'est le cas notamment de certaines sources de lumière dont le matériau de la couche émissive présente, hors contrainte, une structure de bandes d'énergie indirecte, la structure de bandes étant alors rendue directe par l'application d'une contrainte en tension suffisante. Le composé semiconducteur cristallin peut être un composé à base de germanium, par exemple du germanium, du germanium étain, voire du silicium germanium.

L'article de Petykiewicz et al. intitulé Direct Bandgap Light Emission from Strained Ge Nanowires, Nano Lett., 2016, 16 (4), 2168-2173, décrit un exemple de structure semiconductrice comportant une couche semiconductrice réalisée à base de germanium, la couche semiconductrice étant structurée pour former une membrane suspendue au-dessus d'une couche support. La membrane suspendue comporte une portion centrale mise en tension par des portions latérales formant des bras tenseurs. La portion centrale forme le milieu à gain d'une source laser, celui-ci étant situé dans une cavité optique définie par deux miroirs de Bragg. Les miroirs de Bragg sont disposés dans les bras tenseurs, et sont formés par une succession périodique de gravures localisées de la couche semiconductrice.

US2017093130 concerne un procédé de réalisation d'une structure semiconductrice comportant portion contrainte, comportant les étapes dans lesquelles on réalise une cavité située sous une partie structurée de manière à contraindre une portion centrale par des portions latérales.

Il existe cependant un besoin de disposer d'une telle structure semiconductrice dont les propriétés mécaniques de la membrane suspendue sont préservées voire améliorées à la suite de la réalisation de la cavité optique. Il existe également un besoin de disposer d'une telle structure semiconductrice dont les propriétés optiques et/ou électroniques de la membrane suspendue sont préservées voire améliorées.

**EXPOSÉ DE L'INVENTION**

L'invention a pour objectif de remédier au moins en partie aux inconvénients de l'art antérieur, et plus particulièrement de proposer une structure semiconductrice comportant une membrane suspendue réalisée en un composé semiconducteur cristallin, dont les propriétés mécaniques de la membrane suspendue sont préservées voire améliorées après réalisation de la cavité optique, ce qui permet de préserver voire améliorer ses propriétés optiques et/ou électroniques.

Pour cela, l'objet de l'invention est une structure semiconductrice comportant :

- une couche semiconductrice réalisée en un composé semiconducteur cristallin, comportant une membrane suspendue au-dessus d'une couche support, la membrane suspendue étant formée : d'une portion centrale, contrainte en tension dans un plan parallèle à la couche support, formant un guide d'onde apte à supporter au moins un mode optique ; et de plusieurs portions latérales, opposées les unes aux autres vis-à-vis de la portion centrale, et agencées de manière à maintenir la portion centrale suspendue et contrainte en tension, les portions latérales présentant une largeur moyenne supérieure à une largeur moyenne de la portion centrale,

- au moins une cavité optique, délimitée par deux réflecteurs optiques, disposés dans les portions latérales de part et d'autre de la portion centrale.

Selon l'invention, la portion centrale est adaptée à transmettre en direction des réflecteurs optiques au moins un mode d'ordre impair. De plus, chacun desdits réflecteurs optiques est formé de deux demi-réflecteurs latéraux, distincts l'un de l'autre et agencés de part et d'autre d'un axe longitudinal de la portion latérale dans laquelle ils sont disposés, de manière à réfléchir au moins partiellement ledit mode d'ordre impair.

Certains aspects préférés, mais non limitatifs de cette structure semiconductrice sont les suivants.

Les demi-réflecteurs latéraux peuvent présenter chacun un angle principal d'écartement défini entre un axe médian passant par un centre du demi-réflecteur latéral et par une extrémité de la portion centrale située en regard du demi-réflecteur latéral correspondant d'une part, et l'axe longitudinal de la portion latérale d'autre part.

L'angle principal d'écartement peut être supérieur à 25°.

La portion centrale peut présenter une largeur locale, en ses extrémités, supérieure à une largeur moyenne de la portion centrale, et adaptée de sorte que le mode d'ordre impair présente un angle médian de diffusion en direction des demi-réflecteurs latéraux sensiblement égal à l'angle principal d'écartement.

La portion centrale peut présenter une largeur locale, en ses extrémités, supérieure ou égale à $0,8\mu$m. De plus, les demi-réflecteurs latéraux peuvent présenter chacun un angle principal d'écartement supérieur ou égal à 40°.

Le mode d'ordre impair peut être le mode d'ordre 1 (TE01 ; TMo1).

La portion centrale peut être adaptée à transmettre en direction des réflecteurs optiques au plus le mode fondamental et le mode d'ordre 1.

La portion centrale peut être multimode sur toute sa longueur et peut présenter au moins une dimension transversale telle qu'elle autorise la transmission du mode fondamental et d'au plus le mode d'ordre 1.

La portion centrale peut comporter une partie monomode adaptée à supporter le mode fondamental et, disposés entre les portions latérales et la partie monomode, des convertisseurs de mode adaptés à convertir le mode fondamental en le mode d'ordre impair.

Le composé semiconducteur cristallin est de préférence un composé à base de germanium.

La portion centrale présente de préférence une déformation moyenne en tension telle que sa structure de bandes d'énergie est directe.

L'invention porte également sur une source laser comportant une structure semiconductrice selon l'une quelconque des caractéristiques précédentes, dans laquelle la portion centrale forme le milieu à gain de la source laser.

**BRÈVE DESCRIPTION DES DESSINS**

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

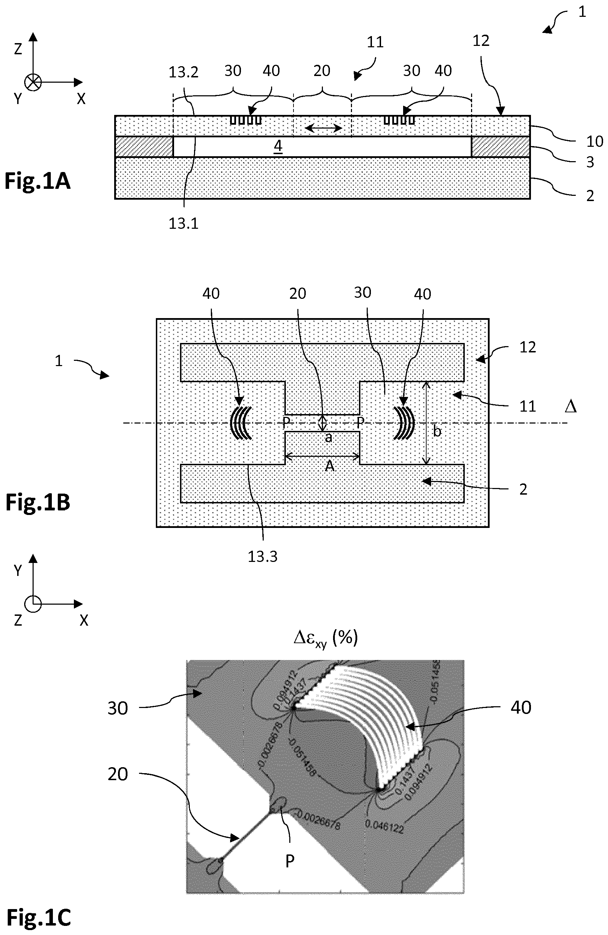

la figure 1A est une vue schématique et partielle en coupe longitudinale d'une structure semiconductrice selon un exemple de l'art antérieur, comportant une membrane suspendue à portion centrale contrainte en tension de manière uniaxiale par des bras tenseurs, ainsi qu'une cavité optique ; la figure 1B est une vue schématique de dessus de la structure semiconductrice illustrée sur la fig.1A ; et la figure 1C illustre une distribution du champ de contraintes mécaniques subies par un bras tenseur représenté sur la fig.iB, mettant en évidence la présence de zones de concentration de contraintes à proximité du réflecteur optique ;

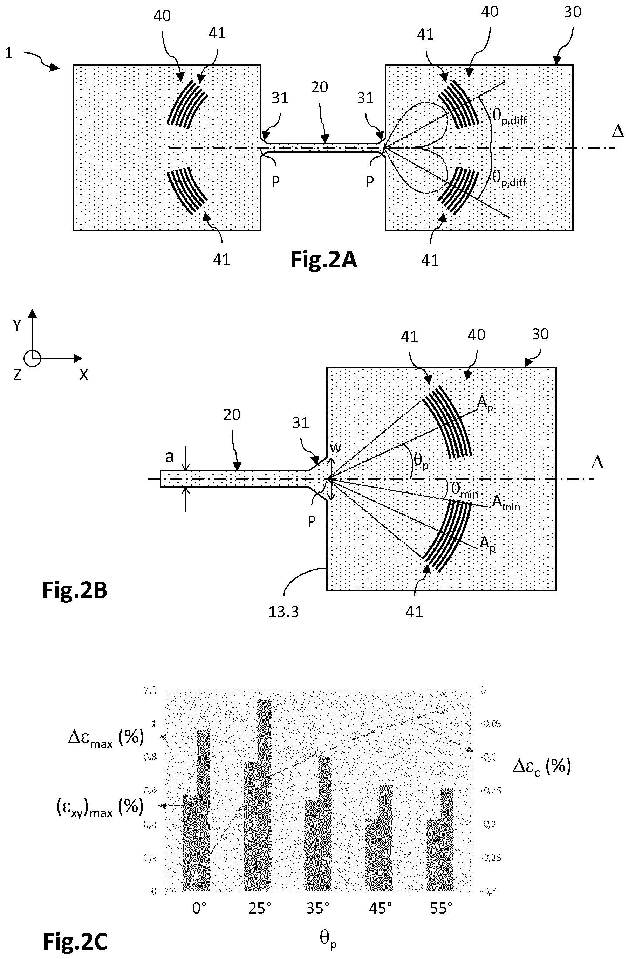

la figure 2A est une vue partielle et schématique d'une structure semiconductrice selon un mode de réalisation, dans lequel chaque réflecteur optique qui délimite la cavité optique est formé de deux demi-réflecteurs latéraux ; la figure 2B est une vue détaillée d'une partie de la membrane suspendue illustrée sur la fig.2A ; et la figure 2C illustre l'influence de l'angle principal d'écartement $\theta_p$ sur :

- le différentiel $\Delta\varepsilon_c$ de déformation subie au centre de la portion centrale avec et sans la cavité optique ;
- la valeur locale maximale $(\varepsilon_{xy})_{max}$ de la déformation subie par un bras tenseur en présence de la cavité optique ;
- l'amplitude maximale $(\Delta\varepsilon)_{max}$ de déformation subie par un bras tenseur en présence de la cavité optique ;

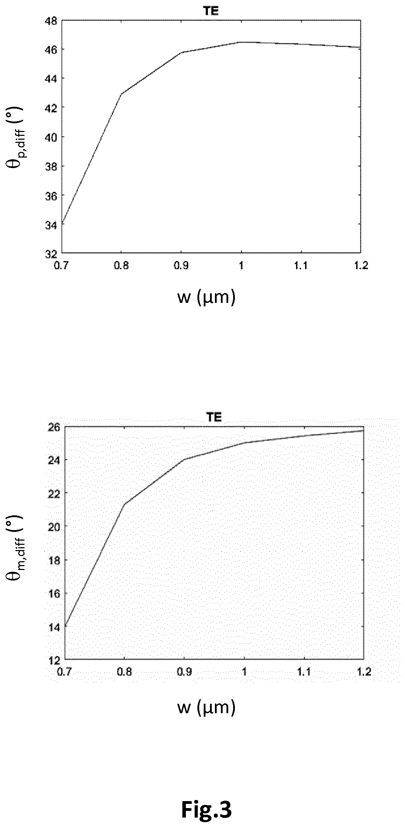

la figure 3 illustre l'influence de la largeur locale w de la partie centrale en ses extrémités P sur l'angle médian $\theta_{p,diff}$ et l'angle minimal $\theta_{m,diff}$ de la diffusion du mode optique TEo1 en direction des demi-réflecteurs latéraux ;

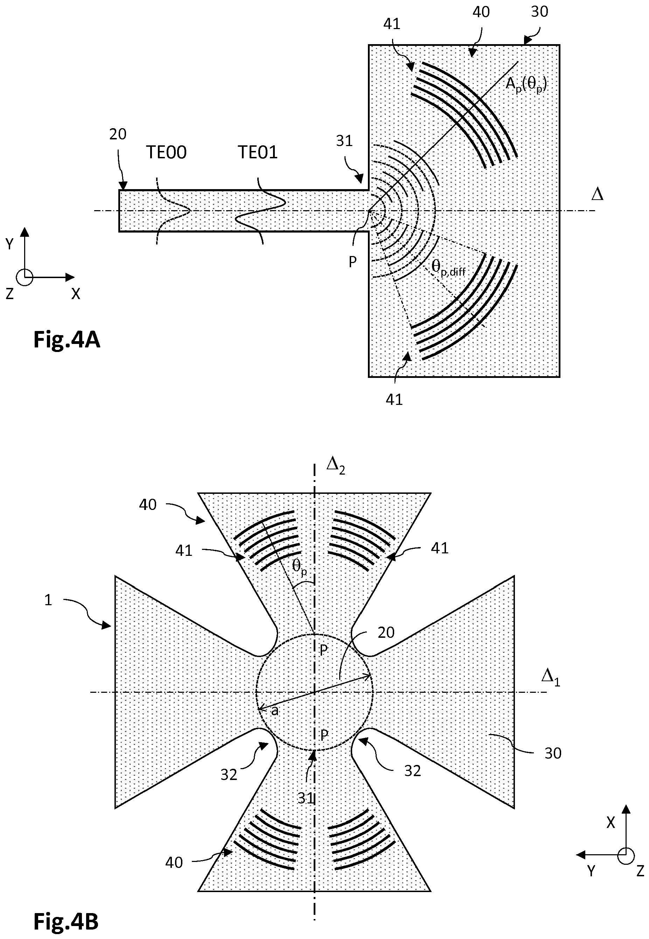

les figures 4A et 4B sont des vues de dessus, schématiques et partielles, de deux exemples différents d'une structure semiconductrice selon un mode de réalisation, dans lequel la portion centrale est multimode et adaptée à supporter, sur toute sa longueur, le mode fondamental et au moins un mode d'ordre supérieur impair, la portion centrale étant contrainte en tension de manière uniaxiale (fig.4A) et de manière biaxiale (fig.4B) ;

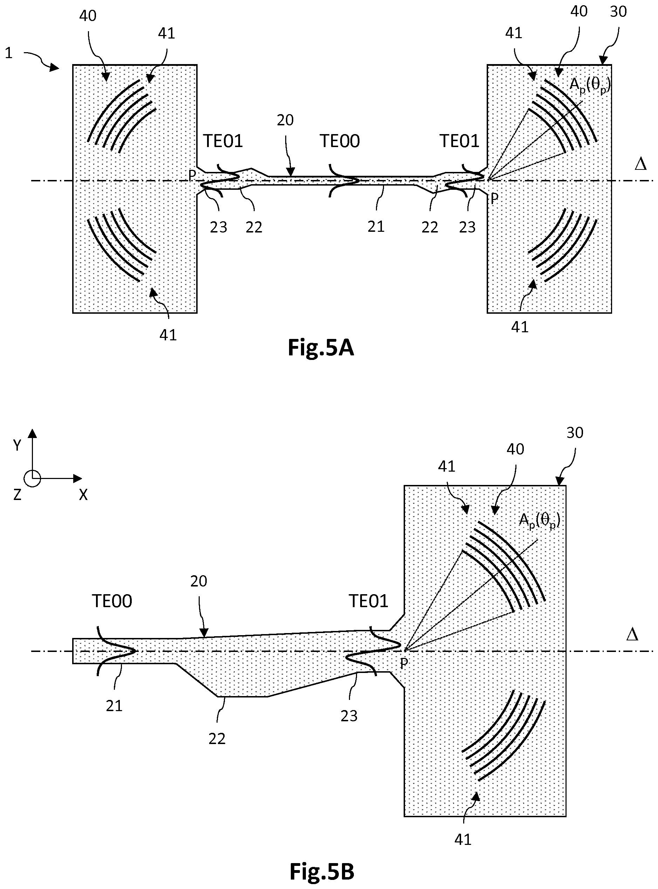

les figures 5A et 5B sont des vues de dessus, schématiques et partielles, d'un exemple d'une structure semiconductrice selon un autre mode de réalisation, dans lequel la portion centrale est structurée pour présenter une partie principale monomode ainsi que deux parties d'extrémité de conversion de mode situées entre la partie monomode et les bras tenseurs, la fig.5B étant une vue détaillée d'une partie de la membrane suspendue illustrée sur la fig.5A.

**EXPOSÉ DÉTAILLÉ DE MODES DE RÉALISATION PARTICULIERS**

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention concerne d'une manière générale une structure semiconductrice comportant une membrane suspendue réalisée en un composé semiconducteur cristallin, la membrane comportant une portion centrale suspendue et mise en tension par des portions latérales formant des bras tenseurs. La membrane suspendue est de préférence réalisée à base de germanium contraint en tension d'une manière suffisante pour que la portion centrale présente, au moins en partie, une structure de bandes d'énergie directe. La portion centrale forme un guide d'onde disposé dans une cavité optique, celle-ci étant délimitée par des réflecteurs optiques disposés dans les bras tenseurs. Dans une application préférée de la structure semiconductrice, la portion centrale forme le milieu à gain d'une source laser.

D'une manière générale, le composé semiconducteur cristallin est de préférence monocristallin, et peut être choisi notamment parmi les éléments de la colonne IV de la classification périodique, tels que le silicium, le germanium, l'étain dans sa phase semiconductrice, et les alliages formés de ces éléments, par exemple le Si-Ge, le GeSn, le SiGeSn. Il peut également être choisi parmi les alliages comportant des éléments des colonnes III et V de la classification périodique, par exemple le GaInAs et l'InP, voire comportant des éléments des colonnes II et VI, par exemple le CdHgTe. De préférence, le composé semiconducteur cristallin présente, en l'absence de déformation en tension de son réseau cristallin, une structure de bandes d'énergie indirecte. Sa structure de bandes est sensiblement directe lorsqu'il subit une déformation en tension suffisante. Il est, de préférence, du germanium ou un alliage à base de germanium.

Par portion contrainte, on entend une portion de couche réalisée en un composé semiconducteur cristallin présentant une contrainte mécanique en tension ou en compression, entraînant une déformation des mailles de son réseau cristallin. La portion est contrainte en tension lorsqu'elle subit une contrainte mécanique qui tend à étirer les mailles du réseau dans un plan. Dans le cadre de l'invention, la portion centrale de la membrane suspendue est contrainte en tension dans le plan de la couche semiconductrice, ce qui se traduit par le fait que son paramètre de maille présente une valeur dite effective supérieure à sa valeur naturelle lorsque le composé semiconducteur est relaxé (i.e. non contraint). Dans la suite de la description, sauf indication contraire, la contrainte considérée est orientée dans le plan de la couche semiconductrice.

Par structure de bandes directe ou sensiblement directe, on entend que le minimum d'énergie $E_{BC,L}$ de la bande de conduction de la vallée L (ou vallée indirecte) est supérieur ou sensiblement égal au minimum d'énergie $E_{BC,\Gamma}$ de la bande de conduction de la vallée $\Gamma$ (ou vallée directe), autrement dit : $\Delta E = E_{BC,L} - E_{BC,\Gamma} \geq 0$. Par sensiblement égal, on entend ici que cette différence d'énergie est de l'ordre de grandeur ou inférieure à kT, où k est la constante de Boltzmann et T la température du matériau. De préférence, la couche semiconductrice est réalisée à base de germanium dont la structure de bandes d'énergie est indirecte en-dehors de la portion centrale de la membrane suspendue, autrement dit $\Delta E < 0$, et la portion centrale présente une déformation en tension suffisante pour rendre sa structure de bandes d'énergie au moins en partie directe.

Les figures 1A et 1B sont des vues partielles et schématiques, en coupe longitudinale (fig.1A) et de dessus (fig.1B), d'une structure semiconductrice 1 à membrane suspendue comportant une cavité optique selon un exemple de l'art antérieur.

On définit ici et pour la suite de la description un repère direct tridimensionnel (X,Y,Z), où les axes X et Y forment un plan parallèle au plan d'une couche support 2, et où l'axe Z est orienté suivant l'épaisseur des couches. Dans la suite de la description, les termes « inférieur » et « supérieur » s'étendent comme étant relatifs à un positionnement croissant lorsqu'on s'éloigne de la couche support 2 suivant la direction +Z.

La structure semiconductrice 1 comporte un empilement formé d'une couche support 2, d'une couche sacrificielle 3 et d'une couche semiconductrice 10 réalisée en un composé semiconducteur cristallin de préférence monocristallin. La couche support 2 peut être réalisée en un matériau choisi parmi le silicium, le saphir, le borosilicate, la silice, le verre, le quartz, ou tout autre matériau adapté. La couche sacrificielle 3 peut être réalisée en un matériau choisi parmi un oxyde ou un nitrure de silicium, entre autres. La couche semiconductrice 10 est réalisée de préférence à base de germanium. La couche sacrificielle 3 peut présenter une épaisseur de l'ordre de quelques dizaines de nanomètres à quelques microns. La couche support 2 peut présenter une épaisseur de quelques dizaines de nanomètres à quelques centaines de microns.

La couche semiconductrice 10 est formée d'une partie structurée 11 suspendue au-dessus de la couche support 2 et d'une partie périphérique 12 qui entoure la partie structurée 11. La partie périphérique 12 repose sur la couche sacrificielle 3, celle-ci formant une cavité 4 située sous la partie structurée 11. La partie structurée 11 comporte une portion centrale 20 reliée à la partie périphérique 12 par des portions latérales 30 formant des bras tenseurs 30. Comme le montrent les figures 1B et 1C, la portion centrale 20 peut présenter une forme, dans le plan (X,Y), sensiblement carrée ou rectangulaire, de quelques centaines de nanomètres à quelques microns de largeur, voire une forme circulaire ou polygonale dans le cas d'une déformation biaxiale. La couche semiconductrice 10 peut présenter, selon les applications électroniques ou optoélectroniques visées, une épaisseur de l'ordre de quelques dizaines de nanomètres à quelques microns, voire davantage. Dans la partie structurée 11, la membrane suspendue présente une face inférieure 13.1 orientée vers la couche support 2 et une face supérieure 13.2 opposée, et des flancs latéraux 13.3 reliant les faces inférieure 13.1 et supérieure 13.2 l'une à l'autre.

Au moins deux portions latérales 30 sont réalisées qui relient chacune une bordure de la portion centrale 20 à la partie périphérique 12. Elles sont agencées deux à deux vis-à-vis de la portion centrale 20 de manière à définir au moins un axe de déformation $\Delta$ sensiblement rectiligne. Dans l'exemple de la figure 1B, une paire de portions latérales 30 sont représentées où ces dernières s'étendent chacune à partie d'une bordure de la portion centrale 20 jusqu'à la partie périphérique 12. Les deux portions latérales 30 sont agencées de manière à définir un seul axe Δ de déformation, ici parallèle à l'axe X. Ainsi, la portion centrale 20 subit une déformation uniaxiale en tension suivant l'axe de déformation Δ. Cet axe de déformation Δ coïncide avec l'axe longitudinal des portions latérales 30.

La portion centrale 20 est une portion contrainte en tension, c'est-à-dire qu'elle présente une déformation de son réseau cristallin par augmentation du paramètre de maille naturel. Les portions latérales 30 permettent d'augmenter la valeur initiale de contrainte en tension dans la portion centrale 20, de préférence sans pour autant subir elles-mêmes une contrainte mécanique significative. Elles forment ainsi des bras tenseurs 30. Pour cela, les bras tenseurs 30 et la portion centrale 20 sont dimensionnés pour que la largeur moyenne « b » des bras tenseurs 30 soit supérieure à la largeur moyenne « a » de la portion centrale 20, de préférence dix fois supérieure à cette dernière. Par largeur, on entend la dimension locale entre les flancs latéraux 13.3 opposés d'une portion ou d'un bras, dans le plan XY. L'épaisseur est la dimension locale entre les faces inférieure 13.1 et supérieure 13.2 suivant l'axe Z. La portion centrale 20 présente une dimension longitudinale de longueur, ici orientée suivant l'axe X, qui coïncide avec l'axe Δ de déformation, et des dimensions transversales de largeur suivant l'axe Y et d'épaisseur suivant l'axe Z.

La portion centrale 20 forme un guide d'onde, qui peut être monomode ou multimode, adapté à supporter un signal optique résonant parcourant la cavité optique. Elle forme ainsi le cœur de haut indice optique du guide d'onde, entouré par du vide, un fluide, voire un matériau d'encapsulation qui forme la gaine de bas indice optique. A titre d'exemple, le guide d'onde 20 peut être dimensionné pour que le signal optique guidé soit polarisé essentiellement en mode TE (transverse électrique), c'est-à-dire qu'il présente un plan de polarisation sensiblement parallèle au plan du guide. Pour cela, il présente une largeur supérieure à son épaisseur. Le guide d'onde 20 peut, en variante, être dimensionné de sorte que son épaisseur soit supérieure à sa largeur, ce qui implique que le signal optique est essentiellement polarisé en mode TM (transverse magnétique). Il peut supporter à la fois un mode TE et un mode TM lorsque ses dimensions transversales de largeur et d'épaisseur sont du même ordre de grandeur ou sont grands par rapport à la longueur d'onde. A titre d'exemple, pour une longueur d'onde d'émission de la source laser à 1,31μm (pour des applications dites datacom) ou à 1,55μm (pour des applications dites télécom), la largeur et l'épaisseur de la portion centrale peuvent être de quelques centaines de nanomètres à quelques microns, par exemple égales à 600nm environ. Dans le cas d'un source laser dont le milieu à gain est la portion centrale réalisée à base de germanium, la longueur d'onde d'émission peut être supérieure ou égale à 1,6μm, par exemple comprise entre 2 et 5μm.

La dimension surfacique dans le plan XY, et en particulier la largeur de chaque bras tenseur 30, peut être choisie de sorte que les bras tenseur 30 présentent une déformation négligeable par rapport à celle subie par la portion centrale 20. Plus précisément, la déformation moyenne locale diminue à mesure qu'on s'éloigne de la portion contrainte 20. Sur l'exemple de la figure 1B, les portions latérales 30 présentent une forme de rectangle, mais d'autres formes sont possibles, par exemple une forme de trapèze dont la largeur augmente continûment à mesure que l'on s'éloigne de la portion centrale 20.

La structuration de la membrane suspendue peut avoir été réalisée de manière à contrôler la valeur de l'amplification de la contrainte en tension de la portion centrale 20, obtenue lors de la réalisation de la cavité 4 et donc lors de la suspension de la membrane. Pour cela, on prédétermine les paramètres dimensionnels de la partie structurée 11, par exemple les largeurs et longueurs de la portion centrale 20 et des bras tenseurs 30. A titre d'exemple, dans le cas d'une portion centrale 20 rectangulaire, de longueur A et de largeur moyenne constante a, et des bras tenseurs 30 rectangulaires de longueur B/2-A/2 et de largeur constante b, un facteur d'amplification f reliant la contrainte finale $\sigma^f$ en tension de la portion centrale 20 à la contrainte initiale $\sigma^i$ en tension peut s'exprimer par la relation suivante formulée dans l'article de Süess et al intitulé Analysis of enhanced light emission from highly strained germanium microbridges, Nature Photon. 7, 466-472 (2013) :

$$ f = \frac{2L + B}{B} \left( 1 + \frac{A}{B - A} \right) \Big/ \left( \frac{a}{b} + \frac{A}{B - A} \right) $$

où L est la longueur de la partie structurée 11 suspendue. Ainsi, en fonction des paramètres dimensionnels de la partie structurée 11 de la couche semiconductrice 10, on est en mesure de contrôler la valeur de l'amplification de la contrainte en tension appliquée à la portion centrale 20 lors de la réalisation de la cavité 4. Le facteur d'amplification peut également être estimé au moyen d'un logiciel de simulation numérique tel que COMSOL Multiphysics.

La structure semiconductrice comporte une cavité optique définie par deux réflecteurs optiques 40, associés optiquement l'un à l'autre et disposés dans les bras tenseurs 30. L'axe optique de la cavité coïncide ici avec l'axe longitudinal Δ de déformation des bras tenseurs 30, et avec l'axe longitudinal de la portion centrale 20. La cavité optique forme une section résonante adaptée à déterminer les longueurs d'onde émises par une source laser à pompage optique ou électronique, dont le milieu à gain serait formé par la portion centrale. L'un des réflecteurs optiques 40 peut être un réflecteur total présentant une réflectivité sensiblement égale à 100% et l'autre réflecteur optique 40 être un réflecteur partiel de manière à permettre l'émission directive d'un signal optique à la longueur d'onde de la cavité Fabry-Pérot. Le réflecteur optique partiel 40 présente alors une réflectivité inférieure à 100%, par exemple égale à 50% environ.

Chaque réflecteur optique 40 est ainsi disposé dans un bras tenseur 30, à une distance ici de quelques microns d'une extrémité P de la portion centrale. Les extrémités P de la portion centrale 20 peuvent être définies à partir de la distribution des contraintes mécaniques, et par exemple lorsque la valeur locale est inférieure de 50% de la valeur moyenne des contraintes mécaniques dans la portion centrale. Elles sont situées ici à la jonction 31 entre la portion centrale 20 et un bras tenseur 30. Dans cet exemple, chaque réflecteur optique 40 est un réseau de Bragg (DBR, pour *distributed Bragg reflector,* en anglais) dont un exemple est illustré dans le document de Petykiewicz 2016 mentionné précédemment. Il est formé d'une pluralité de lignes en arc de cercle parallèles entre elles, formées par gravure localisée de la couche des bras tenseurs 30.

La figure 1C est une vue détaillée d'un réflecteur optique 40 similaire à l'un de ceux illustrés sur la fig.1B, et illustre la présence de zones de concentration des contraintes mécaniques dans les bras tenseurs 30. Plus précisément, la fig.iC représente le différentiel local $\Delta\varepsilon_{xy}$ de déformation subie par la membrane suspendue avec et sans cavité optique. Ce différentiel local $\Delta\varepsilon_{xy}$ de déformation est défini de la manière suivante :

$$\Delta\varepsilon_c = \left[\left(\varepsilon_{xy}\right)_{av} - \left(\varepsilon_{xy}\right)_{ss}\right] / \left(\varepsilon_{xy}\right)_{ss}$$

où $(\varepsilon_{xy})_{av}$ est la valeur de la déformation locale en présence de la cavité optique, et $(\varepsilon_{xy})_{ss}$ est la valeur de la déformation locale en l'absence de la cavité optique pour la même membrane suspendue.

Dans cet exemple, le composé semiconducteur est du germanium, la membrane suspendue présente une épaisseur moyenne de 600nm. La portion centrale 20 présente une longueur de 15µm environ et une largeur de 600nm environ. Elle est ainsi monomode et supporte tant le mode fondamental TE que le mode fondamental TM (transverse magnétique). Les bras tenseurs 30 présentent une largeur de 55µm environ. La portion centrale 20 présente une déformation moyenne en tension de l'ordre de 5,2% permettant d'obtenir une structure de bandes d'énergie directe. Les réflecteurs optiques 40 sont formés chacun d'un miroir de Bragg disposé à une distance de 15µm environ de l'extrémité P et sont situés sur l'axe longitudinal Δ de déformation.

Il en ressort que des zones de concentration de contraintes sont présentes dans les bras tenseurs 30 à proximité des réflecteurs optiques 40, et plus précisément au niveau des bordures latérales des réflecteurs optiques 40. Les zones de concentration sont ici identifiées comme étant les zones de fortes valeurs du différentiel local $\Delta\varepsilon_{xy}$ de déformation. Dans cet exemple, une valeur du différentiel local $\Delta\varepsilon_{xy}$ de l'ordre de 0,55% est présente au niveau des bordures latérales des réflecteurs optiques 40. Ces zones de concentrations de contrainte, liées à la réalisation de la cavité optique dans les bras tenseurs 30, traduisent une dégradation des propriétés mécaniques de la membrane suspendue, et potentiellement une diminution de la tenue mécanique des bras tenseurs 30, et en conséquence de la membrane suspendue. Cela peut entraîner une dégradation des propriétés optiques et/ou électroniques de la membrane suspendue.

Par ailleurs, comme détaillé plus loin en référence à la figure 2C, qui illustre notamment l'influence du positionnement $\theta_p$ des réflecteurs optiques 40 vis-à-vis de l'axe longitudinal Δ, sur la valeur d'un champ $\Delta\varepsilon_c$ de déformation en tension subie au centre de la portion centrale 20, il apparaît que la présence des réflecteurs optiques 40 dans les bras tenseurs 30, et plus précisément leur positionnement $\theta_p$ vis-à-vis de l'axe longitudinal Δ, diminue la valeur de la déformation subie au centre de portion centrale 20. Cette diminution est maximale lorsque les réflecteurs optiques 40 sont positionnés sur l'axe longitudinal Δ ($\theta_p = 0°$). Cela introduit un biais sur les propriétés mécaniques désirées de la membrane suspendue et en particulier de la portion centrale 20. Ce biais est susceptible d'être préjudiciable dans la mesure où il entraîne une modification non voulue des propriétés optiques et/ou électroniques de la membrane suspendue. Plus précisément, du fait de cette diminution, la déformation subie par la portion centrale 20 est susceptible de n'être pas suffisante pour rendre directe sa structure de bandes d'énergie.

La figure 2A est une vue partielle et schématique d'une membrane suspendue à cavité optique selon un premier mode de réalisation, dans laquelle chaque réflecteur optique 40 qui délimite la cavité optique est formé de deux demi-réflecteurs latéraux 41. La figure 2B est une vue détaillée d'une partie de la membrane suspendue illustrée sur la fig.2A.

La portion centrale 20 forme un guide d'onde pour le signal optique se propageant dans la cavité optique. Elle est adaptée à supporter au moins sur une partie de sa longueur, et à transmettre en direction des demi-réflecteurs latéraux 41, au moins un mode guidé d'ordre supérieur au mode guidé fondamental, et plus précisément un mode d'ordre impair. Pour cela, la portion centrale 20 est, au moins en partie, dimensionnée et éventuellement structurée pour supporter ledit mode optique d'ordre impair.

Dans la mesure où le mode d'ordre supérieur est un mode d'ordre impair, il diffuse en direction des demi-réflecteurs latéraux 41 de manière anisotrope à partir des extrémités P de la portion centrale 20. Plus précisément, le mode d'ordre impair diffuse selon un cône de diffusion qui présente un angle médian de diffusion $\theta_{p,diff}$ non nul par rapport à l'axe longitudinal Δ. Autrement dit, le mode d'ordre impair diffuse de part et d'autre de l'axe longitudinal Δ en direction des demi-réflecteurs latéraux 41, suivant des axes de diffusion privilégiés qui forment chacun un même angle $\theta_{p,diff}$ non nul avec l'axe longitudinal Δ. Le mode fondamental au contraire, ainsi que les modes d'ordre supérieur pair, présente une diffusion isotrope de sorte qu'il ne présente pas un angle médian de diffusion non nul vis-à-vis de l'axe longitudinal Δ. De préférence, la portion centrale 20 est adaptée à supporter uniquement le mode impair d'ordre 1, outre le mode fondamental, et non pas les autres modes d'ordre supérieur. Ainsi, dans le cas où la portion centrale 20 supporte le mode fondamental TE00, elle est adaptée à supporter également au plus le mode TE01, et non pas les autres modes TE d'ordre supérieur, par exemple TE02, TE03, mais également TE11, etc. Le mode impair peut être supporté sur toute la longueur de la portion centrale 20 ou sur une partie de sa longueur. Il en est de même pour les modes transverses magnétiques TM : la portion centrale 20 peut être adaptée à supporter également, ou en variante, des modes TM, à savoir le mode fondamental TM00 et de préférence au plus le mode impair TM01.

La portion centrale 20 comporte au moins une zone multimode dans laquelle elle est adaptée à supporter le mode fondamental et au moins, et de préférence au plus, le mode impair d'ordre 1, par exemple ici les modes TE00 et TE01. Dans la mesure où la portion centrale 20 est adaptée à transmettre le mode d'ordre impair en direction des demi-réflecteurs latéraux 41, la ou les zones multimodes sont situées aux extrémités P de la portion centrale 20. Ainsi, comme détaillé plus loin, selon un premier mode de réalisation, la portion centrale 20 peut être multimode sur toute sa longueur et ainsi supporter le fondamental et le mode impair, par exemple les modes TE00 et TE01. En variante, selon un deuxième mode de réalisation, elle peut être monomode sur une majeure partie de sa longueur et être adaptée à supporter le mode fondamental, par exemple le mode TE00, et être multimode en ses extrémités et être adaptée à supporter localement le mode d'ordre impair, par exemple le mode TE01.

La membrane suspendue comporte ainsi deux réflecteurs optiques principaux 40 qui définissent la cavité optique, chaque réflecteur principal 40 étant disposé dans un bras tenseur 30 à une distance sensiblement égale vis-à-vis de la portion centrale 20. Chaque réflecteur principal 40 est formé d'un ensemble de deux demi-réflecteurs latéraux 41 agencés de part et d'autre de l'axe longitudinal Δ du bras tenseur sur lequel ils sont disposés. Chaque demi-réflecteur latéral 41 est une structure réfléchissante vis-à-vis d'au moins le mode optique d'ordre impair transmis par la portion centrale 20. Il présente une réflectivité partielle ou totale.

Chaque demi-réflecteur latéral 41 est une structure réalisée par gravure localisée partielle ou totale suivant l'épaisseur du bras tenseur 30. Il présente ici un axe principal d'écartement $A_p$, qui forme également un axe de symétrie du demi-réflecteur latéral 41. Cet axe d'écartetement $A_p$ passe par l'extrémité P correspondante de la portion centrale 20 et le centre du demi-réflecteur latéral 41, par exemple son barycentre. Il définit un angle principal d'écartement $\theta_p$ avec l'axe longitudinal Δ de déformation. L'extrémité P de la portion centrale 20 est située ici à la jonction 31 avec le bras tenseur 30, et est positionnée sur l'axe longitudinal Δ. Dans le cas de bras tenseurs 30 de forme sensiblement rectangulaire, comme représenté sur la fig.2B, l'extrémité P coïncide sensiblement avec l'intersection entre l'axe longitudinal Δ et un plan parallèle au plan YZ formé par les flancs latéraux 13.3 du bras tenseur 30. Dans le cas (non représenté) de bras tenseurs 30 de forme trapézoïdale, l'extrémité P de la portion centrale 20 peut correspondre à la jonction 31 avec le bras tenseur 30 lorsque la largeur augmente en s'éloignant de la portion centrale 20. Par ailleurs, on peut définir un angle d'écartement minimal $\theta_{min}$ formé entre l'axe longitudinal Δ et un axe $A_{min}$ passant par l'extrémité P considérée et le point du demi-réflecteur latéral 41 le plus proche de l'axe longitudinal Δ. Par définition, dans la mesure où les demi-réflecteurs latéraux 41 d'un même bras tenseur 30 sont distincts les uns des autres, les angles $\theta_{min}$ sont non nuls.

Les demi-réflecteurs latéraux 41 sont disposés à une distance non nulle de la portion centrale 20, définie ici entre l'extrémité P considérée et le point du demi-réflecteur latéral 41 le plus proche, suivant l'axe principal d'écartement $A_p$. Cette distance peut être de l'ordre de quelques microns, par exemple comprise entre $1\mu m$ et $20\mu m$, et de préférence comprise entre $5\mu m$ et $10\mu m$ environ. Les deux demi-réflecteurs latéraux 41 d'un même bras tenseur 30 présentent de préférence, l'un vis-à-vis de l'autre, une symétrie axiale, c'est-à-dire qu'ils présentent des dimensions sensiblement identiques et un positionnement relatif symétrique par rapport à l'axe longitudinal Δ. En outre, les angles d'écartement $\theta_{min}$ et $\theta_p$ sont de préférence identiques pour les deux demi-réflecteurs latéraux 41 d'un même bras tenseur 30. Dans cet exemple, les demi-réflecteurs latéraux 41 sont des miroirs de Bragg, mais il peut également s'agir de structures en coin de cube comme décrit notamment dans l'article de Zabel et al. intitulé Top-down method to introduce ultra-high elastic strain, J. Mater. Res., 2017, 32 (4), 726-736.

Ainsi, le mode guidé d'ordre impair supporté par la portion centrale 20, par exemple le mode TE01, est transmis dans les bras tenseurs 30 en direction des demi-réflecteurs latéraux 41 avec un angle médian de diffusion $\theta_{p,diff}$ non nul. Du fait du positionnement latéral des demi-réflecteurs latéraux 41 de part et d'autre de l'axe longitudinal Δ, une bonne réflectivité du mode d'ordre impair est obtenue, privilégiant ainsi, au sein de la cavité optique, le mode d'ordre impair sur le mode fondamental (lorsque ce mode est également transmis en direction des réflecteurs optiques 40). Le facteur de qualité de la cavité optique associé au mode impair est ainsi meilleur que celui associé au mode fondamental.

La figure 2C illustre l'influence de l'angle prin-

cipal d'écartement $\theta_p$ sur le différentiel $\Delta\varepsilon_c$ de déformation subie au centre de la portion centrale 20, ce différentiel de déformation étant induit par la présence de la cavité optique. Le différentiel $\Delta\varepsilon_c$ de déformation est ici défini de la manière suivante :

$$\Delta\varepsilon_c = [(\varepsilon_c)_{av} - (\varepsilon_c)_{ss}]/(\varepsilon_c)_{ss}$$

où $(\varepsilon_c)_{av}$ est la valeur de la déformation subie au centre de la portion centrale 20 en présence de la cavité optique, et $(\varepsilon_c)_{ss}$ est la valeur de la déformation subie au centre de la portion centrale 20 en l'absence de la cavité optique pour la même membrane suspendue.

Dans cet exemple, la membrane suspendue est réalisée en germanium, et comporte une portion centrale 20 de 600nm environ d'épaisseur et de largeur, et de 15μm environ de longueur. Les bras tenseurs 30 présentent une forme rectangulaire de 55μm environ de largeur pour une épaisseur de 600nm environ. La portion centrale 20 présente une déformation moyenne en tension de l'ordre de 5,2% environ. Les demi-réflecteurs latéraux 41 sont ici des miroirs de Bragg formés chacun d'une pluralité de structurations locales périodiques réalisées dans les bras tenseurs 30. Les miroirs de Bragg sont ici disposés à une distance de 15μm environ de l'extrémité P correspondante de la portion centrale 20, mesurée suivant l'axe principal $A_p$, pour différentes valeurs d'angle principal d'écartement $\theta_p$. Pour l'angle $\theta_p=0°$, chaque réflecteur optique 40 ne comporte qu'un seul miroir de Bragg situé sur l'axe longitudinal $\Delta$ (comme l'illustrent la fig.iB et 1C), et pour les angles $\theta_p>0°$, chaque réflecteur optique 40 comporte deux demi-miroirs 41 de Bragg latéraux (comme l'illustrent les fig.2A et 2B).

Les inventeurs ont constaté que le fait de diviser chaque réflecteur optique 40 en deux demi-réflecteurs latéraux 41, distincts l'un de l'autre et positionné de part et d'autre de l'axe longitudinal $\Delta$, se traduit par une diminution de la valeur du différentiel de déformation $\Delta\varepsilon_c$ au centre de la portion centrale. Ainsi, il apparaît que le différentiel $\Delta\varepsilon_c$ diminue à mesure que l'on augmente l'angle principal d'écartement $\theta_p$ : il passe ainsi d'une valeur maximale de -0,3% environ pour $\theta_p=0°$ (cf. fig.iB et 1C) à -0,15% environ pour $\theta_p=25°$ environ, jusqu'à une valeur quasi-nulle de -0,025% environ pour un angle $\theta_p$ de 55° environ. Ainsi, le fait de réaliser chaque réflecteur optique 40 sous forme de deux demi-réflecteurs latéraux 41 positionnés de part et d'autre de l'axe longitudinal $\Delta$ permet de limiter la diminution de la déformation subie par la portion centrale 20. Les propriétés optiques et/ou électroniques de la membrane suspendue, et en particulier de la portion centrale 20, sont ainsi préservées.

La figure 2C illustre également l'influence de l'angle principal d'écartement $\theta_p$ sur la valeur locale maximale $(\varepsilon_{xy})_{max}$ de déformation subie par chaque bras tenseur 30 en présence de la cavité optique, ainsi que sur l'amplitude maximale $\Delta\varepsilon_{max}$ de déformation subie par chaque bras tenseur 30 en présence de la cavité optique. L'amplitude maximale $\Delta\varepsilon_{max}$ est définie ici comme étant la différence entre la valeur maximale $(\varepsilon_{xy})_{max}$ et la valeur minimale $(\varepsilon_{xy})_{min}$ de déformation subie par le bras tenseur 30 en présence de la cavité optique.

Les inventeurs ont ainsi constaté qu'à partir d'une valeur seuil d'angle principal d'écartement $\theta_p$, ici à partir de 25°, les bras tenseurs 30 présentent une valeur locale maximale $(\varepsilon_{xy})_{max}$ et une amplitude maximale $\Delta\varepsilon_{max}$ qui décroît à mesure que l'angle principal d'écartement $\theta_p$ des demi-réflecteurs latéraux 41 augmente. Cela traduit le fait que les bras tenseurs 30 subissent moins de contraintes mécaniques, et que les zones de concentration des contraintes mécaniques présentent une intensité locale moindre, améliorant ainsi la tenue mécanique des bras tenseurs 30 et donc de la membrane suspendue, ce qui contribue à préserver les propriétés optiques et/ou électroniques de cette dernière.

La figure 3 illustre l'influence de la largeur locale w de la portion centrale 20 en ses extrémités P, c'est-à-dire à la jonction 31 avec les bras tenseurs 30, sur l'angle médian $\theta_{p.diff}$ et sur l'angle minimal $\theta_{m.diff}$ formés par la diffusion du mode impair TE01 en direction des demi-réflecteurs latéraux 41.

Dans cet exemple, la membrane suspendue est réalisée en germanium, et comporte une portion centrale 20 de 600nm environ d'épaisseur et de largeur moyenne, et de 15μm environ de longueur. Les bras tenseurs 30 présentent une forme rectangulaire de 55μm environ de largeur pour une épaisseur de 600nm environ. La portion centrale 20 présente une déformation moyenne en tension de l'ordre de 5,2% environ. Un signal optique se propage dans la cavité optique, à une longueur d'onde de 2,5μm. La portion centrale 20 présente, en ses extrémités P situées à la jonction 31 avec les bras tenseurs 30, une largeur locale w supérieure à la largeur moyenne a. La portion centrale 20 supporte, et transmet en direction des demi-réflecteurs latéraux 41, au moins le mode impair TE01.

Comme mentionné précédemment, l'angle médian $\theta_{p,diff}$ correspond au pic d'intensité du mode optique dans son cône de diffusion. Par ailleurs, l'angle minimal de diffusion $\theta_{m,diff}$ correspond à la valeur maximale de l'intensité lumineuse divisée par $e^2$ (loi gaussienne). Le mode d'ordre impair présente ainsi un profil angulaire en intensité obéissant à une loi gaussienne avec un rayon en $1/e^2$. Il apparaît que le mode impair TE01 diffuse en direction des demi-réflecteurs latéraux 41 avec un angle médian $\theta_{p,diff}$ qui augmente avec la valeur de la largeur locale w. Dans cet exemple, le mode impair TE01 présente un angle en $1/e^2$ de son profil angulaire en intensité de 20° environ. En effet, le cône de diffusion du mode impair TE01 est orienté suivant l'angle médian $\theta_{p,diff}$ qui augmente ici de 34° à 47° environ, pour une largeur locale w de la portion centrale 20 allant de 700nm à 1,2μm. L'angle minimal $\theta_{m,diff}$ augmente ici de 14° à 26°.

Il apparaît par ailleurs qu'une augmentation de la largeur locale w de la portion centrale 20 en ses extrémités P, à partir de 0,8$\mu$m environ, n'induit plus d'augmentation de l'angle médian $\theta_{p,diff}$ de diffusion du mode impair TE01. Aussi, il est avantageux de positionner les demi-réflecteurs latéraux 41 à un angle principal d'écartement $\theta_p$ supérieur ou égal à 40°, par exemple égal à 40° environ, et de dimensionner localement la portion centrale 20 de manière à former une largeur locale w en ses extrémités P d'au moins 0,8$\mu$m environ. Ainsi, par l'écartement important des demi-réflecteurs latéraux 41 de part et d'autre de l'axe longitudinal $\Delta$, on minimise l'intensité des zones de concentration de contrainte dans les bras tenseurs 30 ainsi que la diminution de la déformation subie par la portion centrale 20, tout en optimisant le facteur de qualité de la cavité optique associé au mode impair, ici le mode TE01.

Les figures 4A et 4B sont des vues de dessus, schématiques et partielles, de deux exemples différents d'une structure semiconductrice 1 selon le premier mode de réalisation, dans lequel la portion centrale 20 est multimode sur toute sa longueur et est adaptée à supporter le mode fondamental et au moins un mode d'ordre supérieur impair. Dans ces exemples, la portion centrale 20 est adaptée à supporter le mode fondamental TE00 et au plus le mode impair TE01. Elle peut néanmoins être adaptée à supporter également, ou en variante, des modes transverse magnétique, à savoir le mode fondamental TM00 et le mode impair TM01.

En référence à la figure 4A, la portion centrale 20 présente une forme rectangulaire qui est suspendue et mise en tension de manière uniaxiale suivant l'axe longitudinal $\Delta$ par deux bras tenseurs 30 opposés l'un à l'autre. La portion centrale 20 présente ainsi des dimensions transversales, en épaisseur suivant l'axe Z et en largeur suivant l'axe Y, adaptée à supporter les modes TE00 et TE01 sur toute sa longueur. Les dimensions transversales sont en outre adaptées de sorte qu'elle ne supporte pas les modes d'ordre supérieur à l'ordre 1 tels que les modes TE02 et TE03. Le dimensionnement de la portion centrale 20 est effectué selon les techniques connues de l'homme du métier, en fonction du nombre et du type de modes optiques souhaités et de la longueur d'onde $\lambda_o$ de référence du signal lumineux destiné à être émis par la source laser en fonction des applications photoniques souhaitées.

La cavité optique est définie par deux réflecteurs optiques 40, chacun étant formé de deux demi-réflecteurs latéraux 41 agencés de part et d'autre de l'axe longitudinal $\Delta$ de manière à réfléchir le mode impair TE01. Les demi-réflecteurs latéraux 41 correspondent ici à des miroirs de Bragg, mais en variante peuvent être des structures en coin de cube telles que celles mentionnées précédemment. Ils sont donc disposés suivant un angle principal d'écartement $\theta_p$ sensiblement égal à l'angle médian de diffusion $\theta_{p,diff}$ du mode impair TE01. Le mode fondamental TE00 présente une diffusion sensiblement isotrope, de sorte qu'il est partiellement réfléchi par les demi-réflecteurs latéraux 41. Les deux modes TE00 et TE01 se partagent ainsi le gain, mais le mode impair TE01 est davantage réfléchi par les demi-réflecteurs latéraux que le mode fondamental TE00, de sorte que, au sein de la cavité optique, le mode impair TE01 est privilégié sur le mode TE00 de manière suffisante pour provoquer l'émission de la source laser.

En référence à la figure 4B, la portion centrale 20 présente une forme sensiblement circulaire, suspendue et mise en tension de manière biaxiale suivant deux axes longitudinaux $\Delta_1$ et $\Delta_2$ par deux paires de bras tenseurs 30 opposés deux à deux. Les bras tenseurs 30 présentent ici une forme trapézoïdale dont la largeur augmente à mesure que l'on s'éloigne de la portion centrale 20. La portion centrale 20 présente une surface délimitée ici par un cercle passant par les jonctions 32 entre les bras tenseurs 30 adjacents. Les extrémités P de la portion centrale 20 peuvent être situées ici à l'intersection entre le cercle en pointillé sur la fig.4B et les axes longitudinaux $\Delta_1$ et $\Delta_2$. La largeur de la portion centrale 20, ici orientée suivant l'axe Y orthogonal à l'axe longitudinal $\Delta_2$, rend multimode le guide d'onde que forme la portion centrale 20. Dans la mesure où la largeur suivant l'axe Y est supérieure à l'épaisseur de la portion centrale 20, elle supporte des modes transverses électrique TE. Elle supporte donc le mode fondamental TE00 et au moins le mode impair TE01, et de préférence au plus le mode impair TE01.

La cavité optique est délimitée par les deux réflecteurs optiques 40 formés chacun de deux demi-réflecteurs latéraux 41 agencés sur les bras tenseurs 30 qui s'étendent suivant l'axe longitudinal $\Delta_2$. Les bras tenseurs 30 agencés suivant l'axe longitudinal $\Delta_1$ ne comportent pas, ici, de réflecteurs optiques 40, mais pourraient toutefois en comporter. Les deux demi-réflecteurs latéraux 41 d'un même bras tenseur 30 sont agencés de part et d'autre de l'axe longitudinal $\Delta_2$ pour permettre la réflexion du mode impair TE01. Les demi-réflecteurs latéraux 41 sont ici également des miroirs de Bragg, mais pourraient être des structures en coin de cube. Ils sont donc disposés suivant un angle principal d'écartement $\theta_p$ sensiblement égal à l'angle médian de diffusion $\theta_{p,diff}$ du mode impair TE01.

Une telle structure semiconductrice 1 peut participer à former une source laser à pompage électronique, les porteurs de charge pouvant être ainsi injectés dans la portion centrale 20 par les bras tenseurs 30 orientés suivant l'axe longitudinal $\Delta_1$ qui ne comportent pas de réflecteurs optiques 40. Ces bras tenseurs 30 peuvent ainsi être dopés, l'un de type n et l'autre de type p, et la portion centrale 20 peut être intrinsèque (non intentionnellement dopée).

Les figures 5A et 5B illustrent une structure semiconductrice 1 selon un deuxième mode de réalisation, dans lequel la portion centrale 20 est structurée pour présenter une partie principale 21 monomode et deux parties 22 de conversion de mode, ces dernières étant situées entre la partie monomode 21 et les bras tenseurs 30. La fig.5A est une vue de dessus, schématique et partielle, de la membrane suspendue, et la fig.5B est une vue détaillée d'une partie de la membrane suspendue illustrée sur la fig.5A.

Ainsi, la partie monomode 21 de la portion centrale 20 est adaptée à supporter uniquement le mode fondamental, par exemple ici le mode TE00. Pour cela, la partie monomode 20 présente des dimensions transversales, en épaisseur suivant l'axe Z et en largeur suivant l'axe Y, telles que seul le mode fondamental est supporté. A titre d'exemple, pour une longueur d'onde du signal optique de 2.5µm, la partie monomode 21 peut présenter une épaisseur et une largeur de l'ordre de quelques centaines de nanomètres, par exemple 600m.

Les convertisseurs de mode 22 sont adaptés à assurer la conversion, de préférence adiabatique, de la puissance optique portée par le mode fondamental guidé dans la partie monomode 21 en un mode d'ordre impair, de préférence le mode TE01. Pour cela, la portion centrale 20 présente, sur une longueur définissant les parties 22 de conversion de mode, des dimensions localement ajustées, en épaisseur et/ou en largeur, ici en largeur dans la mesure où les modes supportés sont transverses électriques. Les dimensions transversales et la longueur de conversion peuvent être adaptées de manière à maximiser le coefficient de conversion entre les modes, notamment à l'aide d'un logiciel de simulation numérique des équations de l'électromagnétisme en différences finies dans le domaine temporel (FDTD, pour *Finite Difference Time Domain*). Un exemple de convertisseur de mode est décrit notamment dans le document de Chen et al. intitulé Low-loss and fabrication tolerant silicon mode-ordre converters based on novel compact tapers, Opt. Express 23 (9), 11152-11159. Chaque convertisseur de mode 22 forme ainsi une partie intermédiaire située entre la partie monomode 21 de la portion centrale 20, par exemple de largeur et d'épaisseur de 600nm environ, et, ici, une partie multimode d'extrémité 23 adaptée à supporter le mode TE01, par exemple de largeur de 1µm environ et d'épaisseur de 600nm environ. La partie intermédiaire 22 de conversion de mode présente, dans cet exemple, plusieurs tronçons de différentes longueurs et largeurs, adaptées par simulation numérique, de manière à optimiser l'efficacité de conversion. Les parties multimodes 23 assurent ici la jonction 31 avec les bras tenseurs 30. Elles restent optionnelles et peuvent être omises pour obtenir une partie monomode 21 de grande longueur, permettant ainsi d'optimiser le gain de la source laser. Par ailleurs, la partie intermédiaire 22 peut présenter une variation discontinue ou continue de ses dimensions transversales.

Il apparaît par ailleurs que la présence des parties 22 de conversion de mode ne modifie sensiblement pas la valeur maximale des contraintes mécaniques en tension subies au centre de la portion centrale 20, et influe très peu sur la valeur moyenne des contraintes mécaniques au sein de la portion centrale 20. Une structure semiconductrice 1 selon ce mode de réalisation est ainsi avantageuse dans la mesure où un seul mode optique, ici le mode fondamental TE00, est présent au centre de la portion centrale 20, c'est-à-dire dans la partie monomode 21, et est quasi intégralement converti en le mode d'ordre impair, ici le mode TE01. On augmente ainsi le facteur de qualité de la cavité optique, et on évite de partager le gain de la source laser dans la portion centrale 20 entre le mode fondamental d'une part et le mode d'ordre impair d'autre part.

Des modes de réalisation particuliers viennent d'être décrits. Différentes variantes et modifications apparaîtront à l'homme du métier. Ainsi, dans les exemples de structure semiconductrice selon les différents modes de réalisation décrits précédemment, la portion centrale 20 peut être adaptée à supporter au moins un mode transverse électrique TE, voire au moins un mode transverse magnétique TM. Dans ce cas, la portion centrale 20 présente une épaisseur suivant l'axe Z adaptée de manière à supporter au moins un mode TM. Le mode impair TM01 diverge suivant deux lobes symétriques, de manière similaire à ce qui a été décrit précédemment en référence au mode TE01. La portion centrale 20 peut être adaptée à supporter à la fois au moins un mode TE et au moins un mode TM.

## Revendications

1.   Structure semiconductrice (1), comportant :

       ○ une couche semiconductrice (10) réalisée en un composé semiconducteur cristallin, comportant une membrane suspendue au-dessus d'une couche support (2), la membrane suspendue étant formée :

              • d'une portion centrale (20), contrainte en tension dans un plan parallèle à la couche support (2), formant un guide d'onde apte à supporter au moins un mode optique (TE00, TE01 ; TM00, TM01) ; et
              • de plusieurs portions latérales (30), opposées les unes aux autres vis-à-vis de la portion centrale (20), et agencées de manière à maintenir la portion centrale (20) suspendue et contrainte en tension, les portions latérales (30) présentant une largeur moyenne supérieure à une largeur moyenne de la portion centrale,

       ○ au moins une cavité optique, délimitée par :

              • deux réflecteurs optiques (40), disposés dans les portions latérales (30) de part et d'autre de la portion centrale (20) ;

       **caractérisée en ce que** :

              • la portion centrale (20) est adaptée à transmettre en direction des réflecteurs optiques (40) au moins un mode d'ordre impair (TE01 ; TM01) ;

• chacun desdits réflecteurs optiques (40) est formé de deux demi-réflecteurs latéraux (41), distincts l'un de l'autre et agencés de part et d'autre d'un axe longitudinal (Δ) de la portion latérale (30) dans laquelle ils sont disposés, de manière à réfléchir au moins partiellement ledit mode d'ordre impair (TE01 ; TM01).

2. Structure semiconductrice (1) selon la revendication 1, dans laquelle les demi-réflecteurs latéraux (41) présentent chacun un angle principal d'écartement ($\theta_p$) défini entre un axe médian ($A_p$) passant par un centre du demi-réflecteur latéral (41) et par une extrémité (P) de la portion centrale (20) située en regard du demi-réflecteur latéral (41) correspondant d'une part, et l'axe longitudinal (Δ) de la portion latérale (30) d'autre part.

3. Structure semiconductrice (1) selon la revendication 2, dans laquelle l'angle principal d'écartement ($\theta_p$) est supérieur à 25°.

4. Structure semiconductrice (1) selon la revendication 2 ou 3, dans laquelle la portion centrale (20) présente une largeur locale (w), en ses extrémités (P), supérieure à une largeur moyenne (a) de la portion centrale (20), et adaptée de sorte que le mode d'ordre impair (TEoi ; TM01) présente un angle médian de diffusion ($\theta_{p,diff}$) en direction des demi-réflecteurs latéraux (41) sensiblement égal à l'angle principal d'écartement ($\theta_p$).

5. Structure semiconductrice (1) selon l'une quelconque des revendications 2 à 4, dans laquelle la portion centrale (20) présente une largeur locale (w), en ses extrémités (P), supérieure ou égale à $0,8\mu$m, et dans lequel les demi-réflecteurs latéraux (41) présentent chacun un angle principal d'écartement ($\theta_p$) supérieur ou égal à 40°.

6. Structure semiconductrice (1) selon l'une quelconque des revendications 1 à 5, dans laquelle le mode d'ordre impair est le mode d'ordre 1 (TE01 ; TM01).

7. Structure semiconductrice (1) selon l'une quelconque des revendications 1 à 6, dans laquelle la portion centrale (20) est adaptée à transmettre en direction des réflecteurs optiques au plus le mode fondamental (TE00 ; TM00) et le mode d'ordre 1 (TE01 ; TM01).

8. Structure semiconductrice (1) selon la revendication 7, dans laquelle la portion centrale (20) est multimode sur toute sa longueur et présente au moins une dimension transversale telle qu'elle autorise la transmission du mode fondamental (TE00 ; TM00) et d'au plus le mode d'ordre 1 (TE01 ; TM01).

9. Structure semiconductrice (1) selon l'une quelconque des revendications 1 à 6, dans laquelle la portion centrale (20) comporte une partie monomode (21) adaptée à supporter le mode fondamental (TE00 ; TM00) et, disposés entre les portions latérales (30) et la partie monomode (21), des convertisseurs de mode (22) adaptés à convertir le mode fondamental (TE00 ; TM00) en le mode d'ordre impair (TE01 ; TM01).

10. Structure semiconductrice (1) selon l'une quelconque des revendications 1 à 9, dans laquelle le composé semiconducteur cristallin est un composé à base de germanium.

11. Structure semiconductrice (1) selon l'une quelconque des revendications 1 à 10, dans laquelle la portion centrale (20) présente une déformation moyenne en tension telle que sa structure de bandes d'énergie est directe.

12. Source laser comportant une structure semiconductrice (1) selon l'une quelconque des revendications 1 à 11, dans laquelle la portion centrale (20) forme le milieu à gain de la source laser.

**Patentansprüche**

1. Halbleiterstruktur (1), die umfasst:

◦ eine Halbleiterschicht (10), die aus einer kristallinen Halbleiterverbindung ausgeführt ist und eine oberhalb einer Trägerschicht (2) aufgehängte Membran umfasst, wobei die aufgehängte Membran gebildet ist:

• aus einem mittleren Abschnitt (20), der in einer Ebene parallel zur Trägerschicht (2) auf Zug beansprucht ist und einen Wellenleiter bildet, der geeignet ist, mindestens eine optische Mode (TE00, TE01; TM00, TM01) zu unterstützen; und
• aus mehreren seitlichen Abschnitten (30), die in Bezug auf den mittleren Abschnitt (20) zueinander entgegengesetzt sind und so gestaltet sind, dass sie den mittleren Abschnitt (20) aufgehängt und auf Zug beansprucht halten, wobei die seitlichen Abschnitte (30) eine mittlere Breite aufweisen, die größer als eine mittlere Breite des mittleren Abschnitts ist,

◦ aus mindestens einem optischen Resonator, der begrenzt wird durch:

• zwei optische Reflektoren (40), die in den seitlichen Abschnitten (30) beidseits des mittleren Abschnitts (20) angeordnet sind;

**dadurch gekennzeichnet, dass**:

• der mittlere Abschnitt (20) geeignet ist, in Richtung der optischen Reflektoren (40) mindestens eine Mode ungerader Ordnung (TE01; TM01) zu übertragen;
• jeder der optischen Reflektoren (40) aus zwei seitlichen Halbreflektoren (41) gebildet ist, die voneinander verschieden sind und beidseits einer Längsachse (Δ) des seitlichen Abschnitts (30), in dem sie angeordnet sind, eingerichtet sind, so dass sie die Mode ungerader Ordnung (TE01; TM01) zumindest teilweise reflektieren.

2. Halbleiterstruktur (1) nach Anspruch 1, bei der die seitlichen Halbreflektoren (41) jeweils einen Hauptspreizungswinkel ($\theta_p$) aufweisen, der zwischen einer Mittelachse ($A_p$), die durch einen Mittelpunkt des seitlichen Haltreflektors (41) und durch ein Ende (P) des mittleren Abschnitts (20) verläuft, der dem entsprechenden seitlichen Reflektor (41) gegenüberliegt, einerseits und die Längsachse (Δ) des seitlichen Abschnitts (30) andererseits definiert wird.

3. Halbleiterstruktur (1) nach Anspruch 2, bei welcher der Hauptspreizungswinkel ($\theta_p$) mehr als 25° beträgt.

4. Halbleiterstruktur (1) nach Anspruch 2 oder 3, bei welcher der mittlere Abschnitt (20) eine lokale Breite (w) an seinen Enden (P) aufweist, die größer als eine mittlere Breite (a) des mittleren Abschnitts (20) ist, und so eingerichtet ist, dass die Mode ungerader Ordnung (TE01; TM01) einen mittleren Streuwinkel ($\theta_{p,diff}$) in Richtung der seitlichen Halbreflektoren (41) aufweist, der im Wesentlichen gleich dem Hauptspreizungswinkel ($\theta_p$) ist.

5. Halbleiterstruktur (1) nach einem der Ansprüche 2 bis 4, bei welcher der mittlere Abschnitt (20) eine lokale Breite (w), an seinen Enden (P), größer oder gleich 0,8μm aufweist und bei welcher die seitlichen Halbreflektoren (41) jeweils einen Hauptspreizungswinkel ($\theta_p$) größer oder gleich 40° aufweisen.

6. Halbleiterstruktur (1) nach einem der Ansprüche 1 bis 5, bei der die Mode ungerader Ordnung die Mode der Ordnung 1 (TE01; TM01) ist.

7. Halbleiterstruktur (1) nach einem der Ansprüche 1 bis 6, bei welcher der mittlere Abschnitt (20) geeignet ist, in Richtung der optischen Reflektoren höchstens die Grundmode (TE00; TM00) und die Mode der Ordnung 1 (TE01; TM01) zu übertragen.

8. Halbleiterstruktur (1) nach Anspruch 7, bei welcher der mittlere Abschnitt (20) über seine gesamte Breite mehrmodig ist und mindestens ein solches Quermaß aufweist, dass er die Übertragung der Grundmode (TE00; TM00) und höchstens der Mode der Ordnung 1 (TE01; TM01) zulässt.

9. Halbleiterstruktur (1) nach einem der Ansprüche 1 bis 6, bei welcher der mittlere Abschnitt (20) einen einmodigen Teil (21) umfasst, der geeignet ist, die Grundmode (TE00; TM00) zu unterstützen, und, zwischen den seitlichen Abschnitten (30) und dem einmodigen Teil (21) angeordnet, Modenwandler (22), die geeignet sind, die Grundmode (TE00; TM00) in die Mode ungerader Ordnung (TE01; TM01) umzuwandeln.

10. Halbleiterstruktur (1) nach einem der Ansprüche 1 bis 9, bei der die kristalline Halbleiterverbindung eine Verbindung auf Germaniumbasis ist.

11. Halbleiterstruktur (1) nach einem der Ansprüche 1 bis 10, bei welcher der mittlere Abschnitt (20) eine derartige mittlere Verformung bei Zug aufweist, dass seine Energiebänderstruktur direkt ist.

12. Laserquelle mit einer Halbleiterstruktur (1) nach einem der Ansprüche 1 bis 11, bei welcher der mittlere Abschnitt (20) das Verstärkungsmedium der Laserquelle bildet.

**Claims**

1. Semiconductor structure (1), including:

◦ a semiconductor layer (10) made of a crystalline semiconductor compound, including a membrane suspended above a carrier layer (2), the suspended membrane being formed:

• of a central section (20), which is tensilely stressed in a plane parallel to the carrier layer (2), and which forms a waveguide able to support at least one optical mode (TE00, TE01; TM00, TM01); and
• of a plurality of lateral sections (30), which are opposite one another with respect to the central section (20), and which are arranged so as to keep the central section (20) suspended and tensilely stressed, the lateral sections (30) having an average width larger than an average width of the central section; and

○ at least one optical cavity, bounded by:

• two optical reflectors (40), which are placed in the lateral sections (30) on either side of the central section (20);

**characterized in that**:

• the central section (20) is designed to transmit in the direction of the optical reflectors (40) at least one uneven-order mode (TE01; TM01); and
• each of said optical reflectors (40) is formed of two lateral half-reflectors (41), which are separate from one another and arranged on either side of a longitudinal axis (Δ) of the lateral section (30) in which they are placed, so as to at least partially reflect said uneven-order mode (TE01; TM01).

2. Semiconductor structure (1) according to Claim 1, wherein the lateral half-reflectors (41) each have a main separating angle ($\theta_p$) defined between, on the one hand, a median axis ($A_p$) passing through a centre of the lateral half-reflector (41) and through an end (P) of the central section (20) located facing the corresponding lateral half-reflector (41) and, on the other hand, the longitudinal axis (Δ) of the lateral section (30).

3. Semiconductor structure (1) according to Claim 2, wherein the main separating angle ($\theta_p$) is larger than 25°.

4. Semiconductor structure (1) according to Claim 2 or 3, wherein the central section (20) has a local width (w), at its ends (P), larger than an average width (a) of the central section (20), and designed so that the uneven-order mode (TE01; TM01) has a median scattering angle ($\theta_{p,diff}$) in the direction of the lateral half-reflectors (41) substantially equal to the main separating angle ($\theta_p$).

5. Semiconductor structure (1) according to any one of Claims 2 to 4, wherein the central section (20) has a local width (w), at its ends (P), larger than or equal to 0.8 μm, and wherein the lateral half-reflectors (41) each have a main separating angle ($\theta_p$) larger than or equal to 40°.

6. Semiconductor structure (1) according to any one of Claims 1 to 5, wherein the uneven-order mode is the first-order mode (TE01; TM01).

7. Semiconductor structure (1) according to any one of Claims 1 to 6, wherein the central section (20) is designed to transmit, in the direction of the optical reflectors, at most the fundamental mode (TE00; TM00) and the first-order mode (TE01; TM01).

8. Semiconductor structure (1) according to Claim 7, wherein the central section (20) is multimode over its entire length and has at least one transverse dimension such that it permits the transmission of the fundamental mode (TE00; TM00) and at most the first-order mode (TE01; TM01).

9. Semiconductor structure (1) according to any one of Claims 1 to 6, wherein the central section (20) includes a monomode portion (21) designed to support the fundamental mode (TE00; TM00) and, placed between the lateral sections (30) and the monomode portion (21), mode converters (22) that are designed to convert the fundamental mode (TE00; TM00) into the uneven-order mode (TE01; TM01).

10. Semiconductor structure (1) according to any one of Claims 1 to 9, wherein the crystalline semiconductor compound is a germanium-based compound.

11. Semiconductor structure (1) according to any one of Claims 1 to 10, wherein the central section (20) has an average tensile strain such that its energy band structure is direct.

12. Laser source including a semiconductor structure (1) according to any one of Claims 1 to 11, wherein the central section (20) forms the gain medium of the laser source.

**Fig.1A**

**Fig.1B**

**Fig.1C**

**Fig.2A**

**Fig.2B**

**Fig.2C**

**Fig.3**

**Fig.4A**

**Fig.4B**

**Fig.5A**

**Fig.5B**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017093130 A

**Littérature non-brevet citée dans la description**

- **DE PETYKIEWICZ et al.** Direct Bandgap Light Emission from Strained Ge Nanowires. *Nano Lett.,* 2016, vol. 16 (4), 2168-2173
- **DE SÜESS et al.** Analysis of enhanced light emission from highly strained germanium microbridges. *Nature Photon.,* 2013, vol. 7, 466-472
- **DE ZABEL et al.** Top-down method to introduce ultra-high elastic strain. *J. Mater. Res.,* 2017, vol. 32 (4), 726-736
- **DE CHEN et al.** Low-loss and fabrication tolerant silicon mode-ordre converters based on novel compact tapers. *Opt. Express,* vol. 23 (9), 11152-11159